(19) Europäisches Patentamt
European Patent Office
Office européen des brevets

(11) EP 3 054 027 B1

(12) # EUROPEAN PATENT SPECIFICATION

(45) Date of publication and mention of the grant of the patent:
**25.03.2020 Bulletin 2020/13**

(51) Int Cl.:
***C23C 14/02*** *(2006.01)*

(21) Application number: **16150444.4**

(22) Date of filing: **07.01.2016**

(54) **METHOD FOR ENHANCING ADHESION OF LOW-TEMPERATURE CERAMIC COATING**

VERFAHREN ZUR VERBESSERUNG DER HAFTUNG EINER NIEDERTEMPERATURKERAMIKBESCHICHTUNG

PROCÉDÉ POUR AMÉLIORER L'ADHÉRENCE D'UN REVÊTEMENT CÉRAMIQUE À BASSE TEMPÉRATURE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **04.02.2015 JP 2015020572**

(43) Date of publication of application:
**10.08.2016 Bulletin 2016/32**

(73) Proprietor: **Fuji Kihan Co., Ltd**
**Kita-ku**
**Nagoya-shi**
**Aichi (JP)**

(72) Inventor: **MIYASAKA, Yoshio**
**Nagoya-shi, Aichi (JP)**

(74) Representative: **Lunzarová, Lucie**
**Kania, Sedlak, Smola**
**Patent Attorneys**
**Mendlovo namesti 1a**
**603 00 Brno (CZ)**

(56) References cited:
**WO-A1-2012/095493**
**JP-A- 2005 224 902**
**US-A1- 2012 144 890**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 054 027 B1

## Description

BACKGROUND OF THE INVENTION

### 1. Field of the Invention

The present invention relates to a ceramic coating method and, more particularly to a method for enhancing adhesion of low-temperature ceramic coating by carrying out blasting to metal products such as tools and mechanical parts before formation of the ceramic film with the low-temperature ceramic coating for a surface of the metal product so as to enhance adhesion between the metal products and a ceramic film.

### 2. Description of the Prior Art

In the conventional art, by forming a ceramic component-based thin film on a surface of a metal product with ceramic coating for the metal product, abrasion resistance and fatigue resistance have been impaired to extend the service life.

Such ceramic coating includes CVD (chemical vapor deposition) method, PVD (physical vapor deposition) method, TRD (thermal reactive deposition and diffusion) method, PCVD (plasma CVD) method, and the like.

For example, in the CVD method, source gas including a component of a desired thin film is supplied onto a substrate material heated in a reaction tube to form the thin film by chemical reaction on a surface of a substrate or in a vapor phase.

In the PCVD method, a gaseous raw material is continually supplied to a reaction chamber under reduced pressure and molecules are brought to an excited state by plasma energy to form a thin film on a substrate by vapor phase reaction, substrate surface reaction, or the like.

In the TRD method, powder of metal or oxide mainly containing a carbide forming element is added to a molten salt bath composed of borax or halide, into which a product comprising carbon is immersed and held to coat an article with a carbide layer (mainly VC).

In the PVD method, which is one of the vapor deposition method for depositing a thin film on a surface of a product to be treated without chemical reaction, a solid raw material is used as a raw material of the thin film, vaporized by energy of heat or plasma, and condensed on the surface of the product to be treated to form the thin film. "PVD method" is the general term of three physical vapor deposition methods called vacuum deposition, sputtering, and ion plating, and the ion plating is mainly used for a mold.

Recently, since it has become difficult to meet various needs with only the conventional ceramic coating, composite surface treatment, in which nitriding, blasting, and the like are applied together with the ceramic coating, has been also performed.

As such composite surface treatment, Japanese Patent KOKAI (LOPI) No. 2010-25198 (JP2010-25198A) discloses that a ceramic film is formed after blasting a surface of a steel roller.

However, although the above-described TRD method and CVD method provide excellent adhesiveness and throwing power (uniformity of a coating film) of the thin film, the methods have a problem that treatment temperature is at tempering temperature or higher (about 1,000° C), resulting in deformation and dimensional change of the metal product to be treated. The TRD method and the CVD method also have problems that costs are increased and that a delivery period is lengthened.

On the other hand, since treatment in the PVD method can be performed at tempering temperature or lower (about 200° C to 600° C), the method does not have the problem of deformation and dimensional change of the metal product to be treated. However, adhesiveness and throwing power of the thin film are inferior in comparison with the high-temperature TRD method and CVD method. Therefore, the PVD method is inapplicable to, for example, treatment for a mold to which high surface pressure is applied and for a mold with a complicated shape.

In the above-described TRD method and CVD method, a low-temperature TRD method and a low-temperature CVD method, in which treatment is performed at a low temperature of about 500° C to 600° C, can be also adopted. However, the method cannot provide sufficient adhesion strength of the thin film in comparison with the high-temperature TRD method and CVD method, thus, delamination in use has often become a problem.

In the PCVD method, treatment can be performed at a low temperature of about 450° C to 550° C and adhesiveness of the thin film is excellent in comparison with the PVD method. However, obtained adhesion is not yet enough to meet recent advanced needs.

Although it can be considered as a method for enhancing adhesiveness of the ceramic film that the above-described composite surface treatment is possibly applied to perform blasting, nitriding, or the like which can be carried out at tempering temperature or lower before the ceramic coating, in the case of the composite surface treatment in which the blasting is applied before the ceramic coating, according to the above-described JP2010-25198A, an auxiliary bond layer (intermediate layer) is formed after the blasting to form the film with the ceramic coating, accordingly, costs have been increased.

Furthermore, in the case of the composite surface treatment in which the blasting is applied before the ceramic coating, although low-temperature ceramic coating is carried out at around 450° C to obtain adhesion strength, a compressive stress generated in a surface layer of the product to be treated due to the blasting is suddenly extinguished (numerical value becomes lower) at 300° C or more. Therefore, even if the blasting has been applied before the ceramic coating, an effect of the compressive stress has not been obtained or has become unstable.

On the other hand, in the case of the composite surface treatment in which the nitriding is applied before the ceramic coating, a nitride layer formed on the surface adversely affects adhesion of the ceramic film, so high effect has not been obtained.

As described above, recently, in order to cover highly precise processing with severe dimensional accuracy, the PVD method, the low-temperature CVD method, the low-temperature TRD method, or the PCVD method, in which the treatment can be performed at equal to or lower than tempering temperature of a base material of the metal product so that dimensional change does not occur, has been often adopted. However, in such low-temperature ceramic coating, insufficiency of adhesion of the ceramic film has often become a great problem such as the ceramic film delaminating from the base material in use.

The document US 2012/144890 discloses a method for enhancing adhesion of a ceramic coating, comprising a blasting step comprising mixing spherical shot having three or more different particle sizes within a range of # 280-500, the shot having hardness equal to or higher than hardness of a base material of a metal product, and intermittently ejecting the shot in the form of a fluid mixed with compressed air onto the metal product for a period of 0.1 seconds to 1 second, at intervals of 0.5 seconds to 5 seconds, at an ejection pressure of 0.3 MPa to 0.6 MPa, at an ejection speed of 100 m/sec to 200 m/sec, and at an ejection distance of 100 mm to 250 mm, and a smoothing step comprising polishing a surface to be treated of the metal product to form smooth portions. The amount of smooth portions, as well as the coating temperature are not specified.

Therefore, the present invention has been conceived to solve the above-described problems and is intended to provide a method for enhancing adhesion of the low-temperature ceramic coating in which ceramic film with high adhesion strength can be formed on the metal product with the low-temperature ceramic coating.

## SUMMARY OF THE INVENTION

The present invention is defined by the subject-matter of the appended claims. Means to solve the above problems will now be described below with the terms used in the detailed description of the preferred embodiments. It is intended to clarify correspondence between description of the claims and description of the preferred embodiments for carrying out the invention, and needless to say, is not restrictively used for understanding the technical scope of the present invention.

A method for enhancing adhesion of low-temperature ceramic coating according to the present invention comprises:

a blasting step using spherical shot of # 300-500 according to JIS 6001, the shot having hardness equal to or higher than hardness of a base material of a metal product, and intermittently ejecting the shot in the form of a fluid mixed with compressed air onto the metal product for a period of 0.1 seconds to 1 second, at intervals of 0.5 seconds to 5 seconds, at an ejection pressure of 0.2 MPa to 0.6 MPa, at an ejection speed of 150 m/sec to 250 m/sec, and at an ejection distance of 100 mm to 250 mm;

a smoothing step comprising removing protrusions of irregularities formed by the blasting step on the surface of the metal product by polishing the protrusions to form smooth portions on one-third to two-thirds of the area of the surface to be treated of the metal product; and

a low-temperature ceramic coating step comprising forming a ceramic film on the surface of the metal product at equal to or lower than 650 °C,

the blasting step followed by the smoothing step being carried out before the low-temperature ceramic coating step.

In the blasting step, the blasting may be carried out in two stages under the above described blasting conditions.

In the blasting step, numerous micro-concavities having substantially circular bottom surfaces with diameter of 0.1 μm to 5 μm may be randomly formed on the surface of the metal product.

In the smoothing step, one-third to two-thirds of the area of the surface to be treated of the metal product is polished to form smooth portions.

Preferably, surface roughness of the metal product before the low-temperature ceramic coating step is 0.8 μm (Ra: arithmetic average roughness) or less.

Nitriding may be carried out to the metal product before the blasting step, and preferably, treatment temperature of the nitriding is 500° C to 650° C.

Preferably, decrease rates of the hardness of the base material and the half peak width of the metal product before and after the low-temperature ceramic coating step are within 10 %.

Owing to the above-described configuration according to the present invention, by the blasting step according to the present invention, a surface of a metal product is cleaned at first, hardness of the metal product and a compressive stress in the surface are then increased, and furthermore a numerical value of half peak width described below is increased. Moreover, by the blasting step according to the present invention, instantaneous rapid heating and rapid cooling are repeated on the surface of the metal product and thereby microstructure (nano-crystals) in a surface layer of the metal product is formed. By nano-crystallizing the surface layer of the metal product, a component such as nitrogen, carbon, metal, and the like is easily penetrated and diffused at equal to or lower than tempering temperature so that adhesion strength of a ceramic film is increased even by the ceramic coating at equal to or lower than tempering temperature. Thus, even the ceramic film formed by the low-temperature ceramic coating is hardly delaminated from the surface of the metal product so that the service life of the ceramic film can be extended. Furthermore, removing protrusions on the surface of the metal product by polishing in the smoothing step can prevent the ceramic film from being delaminated.

More specifically, with regard to the adhesion strength of the ceramic film, since the low-temperature ceramic coating is carried out at equal to or lower than tempering temperature, preferably at around 450° C, a numerical value of the compressive stress generated due to the blasting as described above is decreased a little (numerical value becomes lower) while numerical values of hardness of a base material and the half peak width obtained by the blasting are not decreased (effects are not extinguished) at around 450° C, thus nano-crystal structure remains in the surface layer of the metal product during the low-temperature ceramic coating to easily penetrate and diffuse a ceramic component such as carbon, nitrogen, and metal at a low temperature, resulting in enhanced adhesion.

In the blasting step, by carrying out the blasting in two stages, the surface of the metal product is further cleaned, and numerical values of the hardness of the metal product, the compressive stress in the surface, and the half peak width are further improved.

Moreover, by the blasting step according to the present invention, numerous micro-concavities having substantially circular bottom surfaces with diameter of 0.1 μm to 5 μm in various sizes from relatively large ones to small ones are randomly formed on the surface of the metal product (hereinafter, referred to as "mixed micro-dimples"), and the mixed micro-dimples are also formed on a surface after the subsequent ceramic coating, accordingly, in the metal product on which the ceramic film has been formed according to the present invention, effects that mold releasability is good and that fraction defective is little can be obtained.

If the nitriding is carried out as pretreatment, a diffusion layer formed by the nitriding becomes a hardened layer with a tilting structure of which hardness gradually becomes a lower hardness from a high hardness as from the surface becomes deeper, so the nitriding is effective for enhancement of the metal product and improvement of the adhesion of the ceramic film.

Even if a nitride compound layer is formed on the surface of the metal product by the nitriding as pretreatment, the nitride compound layer can be satisfactorily removed by the blasting step according to the present invention.

## BRIEF DESCRIPTION OF THE DRAWINGS

The objects and advantages of the invention will become apparent from the following detailed description of preferred embodiments thereof provided in connection with the accompanying drawings in which:

FIG. 1 is an enlarged view based on a microphotograph of a surface of a metal product onto which blasting according to the present invention has been carried out;
FIG. 2 is an enlarged perspective view showing the surface of the metal product onto which blasting according to the present invention has been carried out;
FIG. 3 is an enlarged view of an area sectioned by a black circle in FIG. 2 and is a schematic view showing an uneven shape on the surface of the metal product before smoothing according to the present invention;
FIG. 4 is an enlarged view of the area sectioned by the black circle in FIG. 2 and is a schematic view showing the uneven shape on the surface of the metal product after the smoothing according to the present invention;
FIG. 5 is a graph showing a roughness curve on the surface of the metal product before the smoothing according to the present invention;
FIG. 6 is a graph showing a roughness curve on the surface of the metal product after the smoothing according to the present invention;
FIG. 7 is a graph showing respective hardness of HAP10 equivalent (press mold), including hardness of a base material, hardness of a product subjected to WPC treatment (registered trademark, simply referred to as "WPC" in the figure), hardness of a product coated with TiN (in the figure, simply referred to as "TiN"), and hardness of a product coated with TiN after subjected to the WPC treatment (registered trademark);

FIG. 8 is a graph showing respective surface roughness of the HAP10 equivalent (press mold), including surface roughness of the base material, surface roughness of the product subjected to WPC treatment (registered trademark, simply referred to as "WPC" in the figure), surface roughness of the product coated with TiN (in the figure, simply referred to as "TiN"), and surface roughness of the product coated with TiN after subjected to the WPC treatment (registered trademark); and

FIG. 9 is a graph showing value variations of hardness, compressive stress, and half peak width to a temperature change.

## DETAILED DESCRIPTION OF THE PREFERRED EMBODIMENTS

The embodiments according to the present invention will now be described below.

A method for enhancing adhesion of low-temperature ceramic coating according to the present invention comprises a blasting step in which a shot is ejected onto a surface to be treated of a metal product, a smoothing step in which the surface to be treated of the metal product is polished to form smooth portions, and a low-temperature ceramic coating step in which a ceramic film composed primarily of TiCN, TiAIN, TiN, CrN, CBN, $TiO_2$, $SiO_2$, $Al_2O_3$, $Y_2O_3$, SiC, WC, TiC, DLC, or the like is formed by the PVD, the low-temperature CVD, the low-temperature TDR, the PCVD, or the like. The blasting step and the smoothing step are carried out before the low-temperature ceramic coating.

According to the present invention, a pretreating step including nitriding, carburizating, and the like may be adequately carried out before the blasting step.

### Product to be treated

The metal product to be treated in the method for enhancing adhesion of low-temperature ceramic coating according to the present invention includes various products composed of metal, such as mold, cutter, sliding part, application tool, cutting tool, decoration part, gear, and bearing.

### Blasting Step

According to the present invention, in the blasting which is carried out before the ceramic coating, the shot is ejected onto the surface of the metal product using a known blasting machine. In the blasting step according the present invention, two-stage blasting may be also carried out under blasting conditions described below.

According to the present invention, various types of the blasting machine are available, including, for example, a direct-pressure type blasting machine that supplies compressed air into a tank containing the shot, causes the shot transported by the compressed air to ride on a flow of separately supplied compressed air, and ejects them via a blasting gun; a gravity type blasting machine that causes the shot falling from a tank to ride on compressed air and ejects them; a suction type blasting machine that sucks the shot with a negative pressure generated by ejecting compressed air to eject the shot together with the compressed air; and the like.

The shot used for the present invention has hardness equal to or higher than that of the metal product to be treated and has the size # 300-500 according to JIS R 6001. As used herein, the term "particle size" refers to a range of average particle diameter, and the term "approximate particle size" refers to a particle size within the above-described range.

Particle size distributions of the shot used in the present invention based on JIS R 6001 are shown in Table 1 and Table 2. Particle sizes of coarse powder are according to Table 1.

Table 1

| Particle size distribution of coarse powders (JIS R 6001) | | | | | | | | | |
|---|---|---|---|---|---|---|---|---|---|
| Particle size | Standard sieve which should be passed through at 100% (One step) | Standard sieve on which powders may be remained up to a fixed amount and the remained amount of the powders (Two steps) | | Standard sieve on which powders may be remained more than a fixed amount and the remained amount of the powders (Three steps) | | Two standard sieves on which powders for the two sieves should be remained more than a fixed amount in total and the remained amount of the powders in total (Three steps + Four steps) | | | Standard sieve which may be passed through up to 3% at the maximum (Five steps) |
| | μ | μ | % | μ | % | μ | | % | μ |
| # 8 | 4000 | 2830 | 15 | 2380 | 45 | 2380 | 2000 | 80 | 1680 |
| #10 | 3360 | 2380 | 15 | 2000 | 45 | 2000 | 1680 | 80 | 1410 |
| #12 | 2830 | 2000 | 15 | 1680 | 45 | 1680 | 1410 | 80 | 1190 |
| #14 | 2380 | 1680 | 15 | 1410 | 45 | 1410 | 1190 | 80 | 1000 |
| #16 | 2000 | 1410 | 15 | 1190 | 45 | 1190 | 1000 | 80 | 840 |
| #20 | 1690 | 1190 | 15 | 1000 | 45 | 1000 | 840 | 80 | 710 |
| #24 | 1190 | 840 | 25 | 710 | 45 | 710 | 590 | 70 | 500 |
| #30 | 1000 | 710 | 25 | 590 | 45 | 590 | 500 | 70 | 420 |
| #36 | 840 | 590 | 25 | 500 | 45 | 500 | 420 | 70 | 350 |
| #46 | 590 | 420 | 30 | 350 | 40 | 350 | 297 | 65 | 250 |
| #54 | 500 | 350 | 30 | 297 | 40 | 297 | 259 | 65 | 210 |
| #60 | 420 | 297 | 30 | 250 | 40 | 250 | 210 | 65 | 177 |
| #70 | 350 | 250 | 25 | 210 | 40 | 210 | 177 | 65 | 149 |
| #80 | 297 | 210 | 25 | 177 | 40 | 177 | 149 | 65 | 125 |
| #90 | 250 | 177 | 20 | 149 | 40 | 149 | 125 | 65 | 105 |
| #100 | 210 | 149 | 20 | 125 | 40 | 125 | 105 | 65 | 74 |
| #120 | 177 | 125 | 20 | 105 | 40 | 105 | 88 | 65 | 63 |
| #150 | 149 | 105 | 15 | 74 | 40 | 74 | 63 | 65 | 44 |
| #180 | 125 | 88 | 15 | 63 | 40 | 63 | 53 | 65 | - |
| #220 | 105 | 74 | 15 | 53 | 40 | 53 | 44 | 60 | - |

A particle size distribution of fine powder based on a testing method using a magnified photograph is according to Table 2.

Table 2

| Particle size distribution of fine powders based on a testing method using magnified photograph (JIS R 6001) unit: μ | | | |
|---|---|---|---|
| Particle size | Average diameter of the largest particle | Average diameter of the 30th particle from the largest particle | Average of average diameters |
| #240 | 171 or less | 120 or less | 87.5 to 73.5 |
| #280 | 147 or less | 101 or less | 73.5 to 62 |
| #320 | 126 or less | 85 or less | 62 to 52.5 |
| #360 | 108 or less | 71 or less | 52.5 to 44 |

(continued)

| Particle size distribution of fine powders based on a testing method using magnified photograph (JIS R 6001) unit: μ | | | |
|---|---|---|---|
| Particle size | Average diameter of the largest particle | Average diameter of the 30th particle from the largest particle | Average of average diameters |
| #400 | 92 or less | 60 or less | 44 to 37 |
| #500 | 80 or less | 52 or less | 37 to 31 |
| #600 | 70 or less | 45 or less | 31 to 26 |
| #700 | 61 or less | 39 or less | 26 to 22 |
| #800 | 53 or less | 34 or less | 22 to 18 |
| #1000 | 44 or less | 29 or less | 18 to 14.5 |
| #1200 | 37 or less | 24 or less | 14.5 to 11.5 |
| #1500 | 31 or less | 20 or less | 11.5 to 8.9 |
| #2000 | 26 or less | 17 or less | 8.9 to 7.1 |
| #2500 | 22 or less | 14 or less | 7.1 to 5.9 |
| #3000 | 19 or less | 12 or less | 5.9 to 4.7 |

Moreover, details of the shots used in the present invention are shown in Table 3-1 and Table 3-2.

Table 3-1

| Quality standard of ceramic system beads | | | | | | |
|---|---|---|---|---|---|---|
| Item / Shot | Shape | Mesh size | Average diameter(μm) | Average diameter of the 30th particle from the largest particle(μm) | Physical property | |
| | | | | | Specific gravity (g/cc) | Mohs hardness |
| Glass beads FGB | Sphere | # 80<br>#100<br>#120<br>#150<br>#180<br>#200<br>#300<br>#400<br>#600 | 250 to 177<br>177 to149<br>149 to125<br>125 to105<br>105 to 88<br>88 to 74<br>62 to 53<br>53 or less<br>44 or less | -<br>-<br>-<br>-<br>-<br>-<br>85 or less<br>60 or less<br>45 or less | 2.46 | 6.0 |
| Hard beads FHB | Sphere | #100<br>#120<br>#150<br>#180<br>#200<br>#300<br>#400 | 180 to 125<br>150 to 106<br>125 to 89<br>106 to 75<br>90 to 63<br>63 to 45<br>53 to 38 | -<br>-<br>-<br>-<br>-<br>85 or less<br>60 or less | 2.60 | 7.5 |

| Components (Reference value) | | | | | | | |
|---|---|---|---|---|---|---|---|
| Component / Shot | $SiO_2$ | $Al_2O_3$ | $B_2O_3$ | $Na_2O$ | $K_2O$ | CaO | MgO |
| Glass beads FGB | 72 | 2 | - | 13 | | 9 | 3 |
| Hard beads FHB | 54 | 14 | 8 | 0.5 | | 22 | 1 |

Table 3-2

| Quality standard of metal beads | | | | | | | | |
|---|---|---|---|---|---|---|---|---|
| Item / Shot | Material | Shape | Mesh size | Average diameter (μm) | Average diameter of the 30th particle from the largest particle (μm) | Physical property | | |
| | | | | | | Den-sity $g/cm^3$ | Bulk specific density | Hardness (HV0.5) 90% or more |
| Steel beads FSS | Cast iron | Sphere | # 50<br># 80<br>#150<br>#300 | 350 to 177<br>250 to 105<br>125 to 44<br>74 to 37 | -<br>-<br>-<br>101 or less | 7.5 to 7.6 | 4.1 to 4.5 | 700 to 800 (HRC 60 to 64) |
| Stain-less beads SUS-304 | Stain-less steel | Sphere | # 50<br># 80<br>#150<br>#300 | 350 to 177<br>250 to 105<br>125 to 44<br>74 to 37 | -<br>-<br>-<br>101 or less | 7.5 to 7.6 | 4.1 to 4.5 | 400 to 600 (HRC 40 to 55) |
| High speed steel beads FHS | high-speed casting steel | Sphere | #300<br>#400 | 74 to 37<br>53 to 30 | 101 or less<br>60 or less | 8.0 to 8.1 | 4.8 to 5.0 | 900 to 1100 (HRC 67 to 70) |

| Components | | | | | | | | | | | | |
|---|---|---|---|---|---|---|---|---|---|---|---|---|
| Compo-nent / Shot | C | Si | Mn | P | S | Cr | Ni | Mo | V | W | Co | Fe |
| Steel beads FSS (%) | 0.9 to 1.1 | <1.3 | <1.0 | <0.05 | <0.05 | | | | | | | BAL |
| Stainless beads SUS-304 (%) | 0.2 to 0.3 | <1.3 | <1.0 | <0.05 | <0.05 | 18 to 20 | 8 to 10.5 | | | | | BAL |
| High speed steel beads FHS (%) | 1.3 | <0.5 | <0.5 | <0.05 | <0.05 | 3 to 5 | | 5 | 3 | 6 | 8 | BAL |

According to the present invention, the ejection process to be performed is intermittent ejection in which ejection for 0.1 seconds to 1 second is repeated at intervals of 0.5 seconds to 5 seconds, at an ejection pressure of 0.2 MPa to 0.6 MPa, at an ejection speed of 150 m/sec to 250 m/sec, and at an ejection distance of 100 mm to 250 mm.

Thereby, instantaneous rapid heating and rapid cooling are repeated on the surface of the metal product to miniaturize (nano-crystallize) of a surface layer. By nano-crystallizing the surface of the metal product, a ceramic component such as nitrogen, carbon, metal and the like is easily penetrated and diffused at equal to or lower than tempering temperature.

In the blasting according to the present invention, numerous micro-concavities having substantially circular bottom surfaces with diameter of 0.1 μm to 5 μm in various sizes from relatively large ones to small ones can be randomly formed on the surface of the metal product. Since grinding effect is exerted due to peening by small beads of the mixed shot and since rapid repeated ejection of the shot at the regular intervals prevents the surface from being damaged excessively, a superior surface layer with small surface roughness can be obtained. FIG. 1 and FIG. 2 are enlarged views of surface states of a metal product on which the blasting according to the present invention has been carried out.

Smoothing step

The method for enhancing adhesion of low-temperature ceramic coating according to the present invention comprises the smoothing step in which the surface to be treated of the metal product is polished to form the smooth portions. The smoothing step according to the present invention can be carried out after the blasting, according to purposes such as a case where the surface roughness is large. Although selection of whether the smoothing is carried out before and/or after the blasting can be made respectively depending on a situation of treatment, it should be carried out before the low-temperature ceramic coating step described below. According to the present invention, the smoothing may be carried out several times. For example, smoothing by hand polishing is carried out once before the blasting and paper lapping is further carried out after the blasting.

Since the ceramic film may be delaminated due to protrusions on the surface of the metal product, the protrusions are removed by polishing in the smoothing step to make the surface of the metal product the flat smooth portions.

The term "smooth portion" as used herein refers to a portion whose surface is flat and smooth after the protrusions of irregularities on the surface of the metal product have been removed by polishing. The remaining concavities serve as mixed micro-dimples as described below.

In the smoothing according to the present invention, by hand polishing with a paper or using a paper lapping machine as well as by blasting, the surface to be treated may be polished to form the smooth portions, and mirror-finishing such as buffing, aerolapping, and lapping including "Sirius processing (registered trademark)" developed by Fuji Manufacturing Co., Ltd. can be also used.

As the paper lapping machine, various paper lapping machines can be used, and, in a general paper lapping machine, a lap tape supported on a tape feeding mechanism is pressed to a workpiece by shoes provided on a pair of lapping arms disposed so as to be movable to/from each other and then lapping is carried out on an outer peripheral surface of the workpiece by rotating the workpiece between the lap tape.

As results of enormous experiments by the inventor, it has been found that numerous micro-concavities having substantially circular bottom surfaces with diameter of 0.1 μm to 5 μm are randomly formed on the surface in the above-described blasting step, that one-third to two-thirds, preferably half, of the area of the surface to be treated is made the smooth portions in the smoothing according to the present invention, and that, when the surface roughness (Ra: arithmetic average roughness) of the metal product is 0.8 μm or less before the low-temperature ceramic coating step described below, a ceramic coating film with high adhesion is formed by carrying out the low-temperature ceramic coating on the surface. The arithmetic average roughness (Ra) is a value calculated by sampling a standard length L from a roughness curve in a direction of an average line of the roughness curve, and then adding up and averaging out absolute values of deviations from the average line to a measuring curve in the sampled part. The arithmetic average roughness (Ra) is determined by the following equation:

$$Ra = \frac{1}{L}\int_0^L |f(x)|dx$$

According to the present invention, in addition to by the smoothing step, by the blasting step in which the small beads of the mixed shot exert the grinding effect due to the peening and the rapid repeated ejection of the shot at the regular intervals prevents the surface from being damaged excessively, the surface roughness (Ra) of the metal product of 0.8 μm or less can be attained.

FIG. 3 shows a surface state of the metal product before the smoothing according to the present invention and FIG. 4 shows a surface state of the metal product after the smoothing according to the present invention. White parts in FIG. 4 show smooth portions which have been formed with the smoothing.

The graph in FIG. 5 shows a roughness curve on the surface of the metal product before the smoothing according to the present invention and the graph in FIG. 6 shows a roughness curve on the surface of the metal product after the smoothing according to the present invention. FIG. 6 shows that, on the surface of the metal product onto which the smoothing according to the present invention has been carried out, protrusions are removed to form smooth portions while mixed micro-dimples formed of micro-concavities remain. By carrying out ceramic coating in this state, the mixed micro-dimples are also formed on a surface after the ceramic coating, thus, in the metal product on which the ceramic film has been formed according to the present invention, effect that mold releasability is good and that fraction defective is little can be obtained. The mixed micro-dimples also serve as solid, liquid, and gas reservoirs in addition to lubricant.

Low-temperature ceramic coating step

According to the present invention, the ceramic coating is carried out to form various known ceramic films composed primarily of TiCN, TiAIN, TiN, CrN, CBN, $TiO_2$, $SiO_2$, $Al_2O_3$, $Y_2O_3$, SiC, WC, TiC, DLC, or the like on the surface of the metal product.

According to the present invention, in order to avoid deformation and dimensional change of the metal product to be treated, the low-temperature ceramic coating such as the PVD, the PCVD, the low-temperature CVD, and the low-temperature TRD, in which the treatment can be performed at equal to or lower than tempering temperature (650° C), preferably at a low temperature region of around 450° C, is used among the conventional ceramic coating.

Although, in the CVD method, a thin film composed of a desired material is obtained by chemical reaction, the low-temperature CVD (LTCVD) in which the treatment is performed at a low temperature region of about 500° C is used according to the present invention.

Although, in the TRD (thermal reactive deposition and diffusion) method, powder of metal or oxide mainly containing a carbide forming element is added to a molten salt bath composed of borax or halide, into which an article comprising carbon is immersed and held to coat the article with a carbide layer (mainly VC), molten salt treatment at a low temperature region of about 500° C to 600° C (low-temperature TRD) is used according to the present invention.

In the PCVD (plasma CVD) method, a gaseous raw material is continually supplied to a reaction chamber under reduced pressure, molecules are brought to an excited state by plasma energy to form a thin film on a substrate by vapor phase reaction, substrate surface reaction, or the like, and the treatment can be performed at a low temperature of about 450° C to 550° C.

In the PVD method, which is one of the vapor deposition methods for depositing a thin film on the surface of the product to be treated without chemical reaction, a solid raw material is used as a raw material of the thin film, vaporized by energy of heat or plasma, and condensed on the surface of the product to be treated to form the thin film, and the treatment can be performed at a low temperature of about 200° C to 600° C. More specifically, the PVD method can include various vacuum deposition such as electron-beam heating, resistive heating, and flash evaporation; various sputtering such as plasma deposition, pole sputtering, direct current sputtering, direct current magnetron sputtering, radio frequency sputtering, magnetron sputtering, ion beam sputtering, and bias sputtering; various ion plating such as DC (direct current) method, RF method, multicathode method, activated reaction method, electric field vapor deposition method, radio frequency ion plating, and reactive ion plating; laser ablation; and the like.

Pretreating step

As described above, according to the present invention, hand polishing, quenching, tempering, nitriding, carburizating, and the like may be carried out to the metal product as pretreatment of the blasting step. The pretreatment is adequately performed corresponding to needs and therefore does not need to be performed.

In the case of the nitriding, a diffusion layer formed by the nitriding becomes a hardened layer with a tilting structure of which hardness gradually becomes a lower hardness from a high hardness as from the surface becomes deeper. Thus, the nitriding is effective for enhancement of a base material and improvement of the adhesion of a hard thin film such as ceramics.

As the nitriding, a nitriding method such as ionitriding (plasma nitriding) and radical nitriding can be applied. In the ionitriding, although hardened layer depth can be effectively ensured, a fragile nitride compound layer is easily formed on the surface of the product to be treated and the surface roughness after treatment increases, so posttreatment such as polishing is necessary after the nitriding. However, since the nitride compound layer can be removed in the above-described blasting step, there is no problem even if the ionitriding is applied in the present invention.

On the other hand, in the radical nitriding, a nitrogen diffusion layer can be formed on the product to be treated without forming the nitride compound layer on the surface.

Preferable specific conditions of the nitriding are such that treatment temperature is 500° C to 650° C (more preferably 500° C to 575° C): and treatment time is 4 to 12 hours (more preferably 6 to 10 hours). If the treatment temperature of the nitriding is more than 650° C, deformation and dimensional change of the metal product is easily generated, and if the treatment temperature is lower than 500° C, nitridation depth (hardened layer depth) easily becomes shallow.

Since a numerical value of the half peak width is increased by the blasting according to the present invention, it is considered that a metal structure in the surface of the metal product onto which the blasting according to the present invention has been carried out is nano-crystallized.

A compressive stress generated in the surface layer of the product to be treated due to the blasting is suddenly extinguished (numerical value becomes lower) when the temperature becomes 300° C or more, and the hardness is also extinguished (numerical value becomes lower) when the temperature becomes 500° C or more, but the half peak width is effective (numerical value is not decreased) even at 500° C or more.

Moreover, the low-temperature ceramic coating step according to the present invention is carried out at equal to or lower than tempering temperature, preferably at around 450° C, accordingly, even if the numerical value of the compressive stress is decreased in some extent, the value of the compressive stress is equal to or higher than that in no treatment case and that in a single nitriding case. The numerical values of the hardness of the base material and the half peak width are maintained. In other words, the structure in the surface layer of the metal product onto which the blasting according to the present invention has been carried out is nano-crystallized, and during the low-temperature ceramic coating step according to the present invention, the structure in the surface layer of the metal product is maintained in a nano-crystals state.

With regard to a principle of forming the ceramic film, it is considered that an activated ceramic component in a ceramic coating is activation-adsorbed on the surface of the product to be treated, and is diffused and penetrated in the surface layer. During the low-temperature ceramic coating step according to the present invention, the structure in the surface layer of the metal product as the product to be treated is maintained in the nano-crystals state, which promotes the penetration and diffusion of the ceramic component, such as carbon, nitrogen, and metal, within the metal structure in the surface layer even at low temperature, so the adhesion of the ceramic film is enhanced.

The inventor has carried out extensive studies and has found that, by making half peak width of the metal product after the blasting step 3.5 or more in a range of hardness HV350 to HV600, and 5.0 or more in a range of hardness more than HV600, a ceramic film with higher adhesion is formed by the low-temperature ceramic coating according to the present invention,

Example 1 (comparative)

In the Example 1, blasting (two-stage treatment) was carried out to a hand polished metal press mold as the product to be treated, under the ejection conditions described in the following Table 4-1. The blasting was carried out by manually vibrating a nozzle 100 mm, 60 times per minute. As a result, half peak width in the Example 1 was 6.0.

In Comparative Example 1, the blasting was not carried out to the same hand polished metal press mold as the Example 1.

In both the above-described Example 1 and Comparative Example 1, ceramic coating was carried out at 450° C by the PVD method under the same conditions to form TiN with a thickness of about 2 μm. Half peak width in the Comparative Example 1 was 4.8.

Table 4-1

| | EXAMPLE 1 | |
|---|---|---|
| | 1st step | 2nd step |
| Blasting machine | Blasting machine for FDC fine powder (direct pressure type) | Blasting machine for SC fine powder |
| Metal product | Metal press mold | |
| Material of metal product | HAP10 powder high-speed steel | |
| Ejection pressure | 0.4 MPa | 0.4 MPa |
| Diameter of ejection nozzle | φ5 | φ9 |
| Ejection speed | 200 m/sec | 150 m/sec |
| Ejection distance | 200 mm | 200 mm |
| Treatment time | 50×100×75H<br>60 sec | 60 sec |
| Shot material | High-speed steel beads (HV 1000) | Alumina-silica beads (HV800) |
| Shot particle size | FHS#400 (30 μm to 53 μm) | FHB#500 (26 μm to 53 μm) |

Results of comparison between the Example 1 and the Comparative Example 1 are shown in the following Table 4-2. In Table 4-2, the surface roughness Ra, the surface hardness HV, and the surface stress MPa are numerical results before the ceramic coating after the blasting.

Table 4-2

| RESULT OF COMPARISON BETWEEN EXAMPLE 1 AND COMPARATIVE EXAMPLE 1 | | | |
|---|---|---|---|
| | | COMPARATIVE EXAMPLE 1 | EXAMPLE 1 |
| Before coating: | Surface roughness Ra | 0.1 μm | 0.15 μm |
| | Surface hardness HV | 930 | 1200 |
| | Surface stress MPa | -300 | -1500 |
| After coating: | Service life, number of shots | 100000 | 2000000 |

Although, in both the Example 1 and the Comparative Example 1, compressive stresses in surfaces after the ceramic coating were -500 MPa, in the Example 1, an effect that the service life of a ceramic film was dramatically extended was obtained. The high compressive stress generated by the blasting before the ceramic coating (PVD) in the Example 1 was extinguished once due to the treatment temperature (450° C) of the PVD, and the numerical value became lower (a compressive stress of a base material in the Example 1 was -1000 MPa and a compressive stress of a base material in the Comparative Example 1 was -100 MPa). However, the compressive stress remained inside the ceramic film which was newly formed by the PVD. Since a compressive stress of the ceramic film was measured after the ceramic coating, the value of the compressive stress in the surface in the Example 1 after the PVD is a value of the compressive stress in the surface of the ceramic film formed by the PVD and therefore was the same value as the Comparative Example 1 in which the PVD under the same conditions as the Example 1 was performed without the blasting. The application of the compressive stress in the ceramic coating may be caused by induction of dissimilar atoms, holes, and gaps; existence of crystal structure and crystal grain boundaries; a misfit of a lattice between dissimilar materials; and the like.

It is considered that, since the base material of the metal product in the Example 1 was HAP10 (powder high-speed steel) with high hardness, uniform nano-crystals were formed in a surface, therefore, adhesion strength of the ceramic film was increased.

FIG. 7 is a graph showing respective hardness of four patterns, including the base material (HAP10), a pattern in which the blasting (WPC treatment (registered trademark): hereinafter, referred to as "WPC treatment") was carried out to the base material under the ejection conditions described in Table 4-1, a pattern in which the base material was coated with TiN, and a pattern in which the base material was coated with TiN after subjected to the WPC treatment. FIG. 8 is a graph showing respective surface roughness of the above-described four patterns.

FIG. 7 shows that, since the powder high-speed steel (HAP10) has high hardness of HV930, the base material subjected to the WPC treatment in the Example 1 has high hardness of HV 1200.

Therefore, it is considered that, in the Example 1, after the blasting according the present invention, uniform nano-crystals and microstructure were formed on the surface. This structure is maintained as long as a temperature is increased to tempering temperature orhigher, thus, it is considered that, when the PVD was performed, titanium and nitrogen as the ceramic component were penetrated and diffused, resulting in an extension effect of the service life of the ceramic film.

FIG. 8 shows that the surface roughness of the base material (HAP10) + the WPC + the TiN coating is Kz0.65μm, thus, mixed micro-dimples were also formed after the TiN coating. FIG. 7 shows that the hardness of the base material (HAP10) + the WPC + the TiN is HV1480, accordingly, it is considered that the half peak width was also maintained at 6.0.

Example 2 (comparative)

In the Example 2, blasting (one-stage treatment) was carried out to a hand polished pudding mold, 50 mm in diameter and 30 mm in height, as the product to be treated, under the ejection conditions described in the following Table 5-1, and then ceramic coating was carried out at about 450° C by the PVD method to form TiN with a thickness of about 2 μm on a surface of the product.

In Comparative Example 2, the blasting was not carried out to the same hand polished pudding mold as the product to be treated in the Example 2, and the ceramic coating was carried out under the same conditions as the Example 2 to form a TiN film with a thickness of about 2 μm on a surface of the product.

Table 5-1

| EXAMPLE 2 | |
|---|---|
| Blasting machine | Blasting machine for SC fine powder |
| Metal product | Pudding mold (φ50×30H) |
| Material of metal product | SUS304 (Stainless) |
| Ejection pressure | 0.4 MPa |
| Diameter of ejection nozzle | φ9 mm (Nozzle vibration: 60 times per minute, Vibration: 50 mm) |
| Ejection speed | 150 m/sec |
| Ejection distance | 200 mm |
| Treatment time | Inner diameter 30 sec, 3 directions, 12 rotations per minute |
| Shot material | Alumina-silica beads (about HV800) |
| Shot particle size | FHB#500 (26 μm to 53 μm) |

Results of comparison between the Example 2 and the Comparative Example 2 are shown in the following Table 5-2. In Table 5-2, the surface roughness Ra, the surface hardness HV, and the surface stress MPa are numerical results before the coating after the blasting.

Table 5-2

| RESULT OF COMPARISON BETWEEN EXAMPLE 2 AND COMPARATIVE EXAMPLE 2 | | | |
|---|---|---|---|
| | | COMPARATIVE EXAMPLE 2 | EXAMPLE 2 |
| Before coating: | Surface roughness Ra | 0.1 μm | 0.2 μm |
| | Surface hardness HV | 350 | 500 |
| | Surface stress MPa | -300 | -500 |
| After coating: | Service life, number of shots | 8000 | 40000 |

The results of the Example2, in which the blasting according to the present invention was carried out, show that the numerical values of the surface roughness Ra, the surface hardness HV, and the surface stress MPa before the ceramic coating are improved in comparison with the Comparative Example 2 in which the blasting was not carried out.

In both the Example 2 and the Comparative Example 2, compressive stresses in surfaces after the TiN coating were -500 MPa. Compressive stresses in surfaces of a base material coated with TiN (inside of the TiN film) were 0 MPa in the Comparative Example 2 and -300 MPa in the Example 2.

However, in the Example 2, adhesion of the ceramic coating was increased, so the service life was extended to 5 times the Comparative Example2. It is considered that, since hardness of SUS304 as the base material is low, nano-crystals and microstructure were formed at a shallow position from the surface in the Example 2 in which the blasting was carried out, so diffusion and penetration of titanium (Ti) and nitrogen (N) as ceramic components were promoted, resulting in the 5 times service life extension. Although the stainless steel has relatively low hardness, it has low heat conductivity of 0.039, so the nano-crystals and the microstructure are easily formed due to rapid heating.

From facts that half peak width in the Example 2 was 4.5, while half peak width in the Comparative Example 2 was 2.5, and that the service life in the Example 1 was extended, it can be understood that a metal structure of a surface layer in the Example 2 was minuter than a metal structure of a surface layer in the Comparative Example 2 and nano-crystallized, and had higher adhesion strength of the coating.

In the Example 2, since mixed micro-dimples were also formed on the surface after the ceramic coating, mold releasability was good and fraction defective was little.

Example 3

In the Example 3, blasting (two-stage treatment) was carried out to a hand polished press drawing die made of SPH as the product to be treated, under the ejection conditions described in the following Table 6-1. The blasting was carried out by setting the product to be treated on a table, rotating the product at one rotation per ten seconds, and vibrating a nozzle 100 mm at a center. After the blasting, paper lapping was lightly carried out.

In Comparative Example 3, the blasting was not carried out to the same hand polished press drawing die made of SPH as the product to be treated in the Example 3.

In both the above-described Example 3 and Comparative Example 3, ceramic coating was carried out at 450° C by the PVD method under the same conditions to form TiCN with a thickness of about 3 μm. Base materials of the press drawing dies had been subjected to tempering twice at 530° C.

Table 6-1

| EXAMPLE 3 | | |
|---|---|---|
| | 1st step | 2nd step |
| Blasting machine | Blasting machine for SC fine powder | Blasting machine for SC fine powder |
| Metal product | Press drawing die | |
| Material of metal product | SKD11 equivalent, Hitachi SLD8 | |
| Ejection pressure | 0.6MPa | 0.4MPa |
| Diameter of ejection nozzle | φ9 mm | φ9 mm |
| Ejection speed | 200 m/sec | 150 m/sec |
| Ejection distance | 150 mm | 200 mm |
| Treatment time | φ50 150×150×50H<br>45 sec | 45 sec |
| Shot material | High-speed steel beads (HV1000) | Alumina-silica beads (About HV800) |
| Shot particle size | FHS#400 (30 μm to 53 μm) | FHB#500 (26 μm to 53 μm) |

Results of comparison between the Example 3 and the Comparative Example 3 are shown in the following Table 6-2. In Table 6-2, the surface roughness Ra, the surface hardness HV, and the surface stress MPa are numerical results before the coating after the blasting.

Table 6-2

| RESULT OF COMPARISON BETWEEN EXAMPLE 3 AND COMPARATIVE EXAMPLE 3 | | | |
|---|---|---|---|
| | | COMPARATIVE EXAMPLE 3 | EXAMPLE 3 |
| Before coating: | Surface roughness Ra | 0.1 μm | 0.15 μm |
| | Surface hardness HV | 750 | 1100 |
| | Surface stress MPa | -200 | -1100 |
| After coating: | Service life, number of shots | 30000 | 200000 |

Compressive stresses in surfaces of the base materials coated with TiCN (inside of a TiCN film) were +200 MPa in the Comparative Example 3 and -900 MPa in the Example 3.

In the conventional art, the TiCN coating has been carried out by the CVD method, and the service life has been 30,000 shots. In contrast, in the Example 3, the service life was extended to 200,000 shots even though the low-temperature PVD method was applied.

From a fact that half peak width in the Comparative Example 3 was 4.0, while half peak width in the Example 3 was 5.2, it can be understood that a metal structure of a surface layer in the Example 3 was minuter than a metal structure of a surface layer in the Comparative Example 3.

Example 4

In the Example 4, blasting (two-stage treatment) was carried out to a hand polished piercing punch φ8 as the product to be treated, under the ejection conditions described in the following Table 7-1. The blasting was carried out by setting the product to be treated on a table, rotating the product at one rotation per three seconds, and vibrating a nozzle 100 mm at a center. After the blasting, paper lapping was lightly carried out.

In Comparative Example 4, the blasting was not carried out to the same piercing punch φ8 as the product to be treated in the Example 4.

In the Comparative Example 4, ceramic coating was carried out at 1100° C by the CVD method to form TiC with a thickness of about 4 μm on a surface, while, in the Example 4, ceramic coating was carried out at 500° C by the PCVD method to form TiCN with a thickness of about 3 μm on a surface.

Table 7-1

| EXAMPLE 4 | | |
|---|---|---|
| | 1st step | 2nd step |
| Blasting machine | Blasting machine for SC fine powder | Blasting machine for SC fine powder |
| Metal product | Piercing punch φ8 for S156 plug component | |
| Material of metal product | HAP10 powder high-speed steel | |
| Ejection pressure | 0.6 MPa | 0.4 MPa |
| Diameter of ejection nozzle | φ9 mm | φ9 mm |
| Ejection speed | 200 m/sec | 150 m/sec |
| Ejection distance | 150 mm | 200 mm |
| Treatment time | 10 sec, 3 sec per 1 rotation | 10 sec, 3 sec per 1 rotation |
| Shot material | High-speed steel beads (HV1000) | Alumina-silica beads (About HV800) |
| Shot particle size | FHS#400 (30 μm to 53 μm) | FHB#500 (26 μm to 53 μm) |

Results of comparison between the Example 4 and the Comparative Example 4 are shown in the following Table 7-2. In Table 7-2, the surface roughness Ra, the surface hardness HV, and the surface stress MPa are numerical results before the coating after the blasting.

Table 7-2

| RESULT OF COMPARISON BETWEEN EXAMPLE 4 AND COMPARATIVE EXAMPLE 4 | | | |
|---|---|---|---|
| | | COMPARATIVE EXAMPLE 4 | EXAMPLE 4 |
| Before coating: | Surface roughness Ra | 0.1 μm | 0.15 μm |
| | Surface hardness HV | 930 | 1200 |
| | Surface stress MPa | -300 | -1500 |
| After coating: | Service life, number of shots | CVD, TiC, 100000 | PCVD, TiCN 300000 |

In the Comparative Example 4, compressive stress after the TiC coating by the CVD was +100 MPa, while, in the Example 4, compressive stress after the TiCN coating by the PCVD was -600 MPa. The compressive stress in the Example 4 was extinguished due to heat caused by the ceramic coating.

However, from a fact that half peak width in the Comparative Example 4 was 4, while half peak width after the coating in the Example 4 was a high numerical value of 6.0, it is considered that, in the Example 4, since nano-crystals formed in a surface layer by the blasting were held, adhesion strength of a ceramic film was increased, so the shot service life was extended.

In the Example 4, mixed micro-dimples were also formed on the surface after the PCVD.

Example 5

In the Example 5, after nitriding was carried out to a pin for die casting mold as the product to be treated at 570° C, blasting (two-stage treatment) was carried out under the ejection conditions described in the following Table 8-1, and then paper lapping finish was carried out.

In Comparative Example 5, after the nitriding was carried out to the same pin for die casting mold as the product to be treated in the Example 5 at 570° C, the paper lapping finish was carried out without the blasting. In both the Comparative Example 5 and the Example 5, ceramic coating was carried out at 450° C by the PVD method to form CrN with a thickness of about 3 μm.

Table 8-1

| EXAMPLE 5 | | |
|---|---|---|
| | 1st step | 2nd step |
| Blasting machine | Blasting machine for FDC fine powder (direct pressure type) | Blasting machine for SC fine powder |
| Metal product | Pin for die casting mold | |
| Material of metal product | SKD61 nitrided product | |
| Ejection pressure | 0.4 MPa | 0.4 MPa |
| Diameter of ejection nozzle | φ5 | φ9 |
| Ejection speed | 150 m/sec | 180 m/sec |
| Ejection distance | 200 mm | 200 mm |
| Treatment time | φ30×200L, 30 sec | φ30×200L, 30 sec |
| Shot material | High-speed steel beads (HV1000) | Alumina-silica beads (HV800) |
| Shot particle size | FHS#300 (37 μm to 74 μm) | FHB#350 (38 μm to 63 μm) |

Results of comparison between the Example 5 and the Comparative Example 5 are shown in the following Table 8-2. In Table 8-2, the surface roughness Ra, the surface hardness HV, and the surface stress MPa are numerical results before the coating after the blasting.

Table 8-2

| RESULT OF COMPARISON BETWEEN EXAMPLE 5 AND COMPARATIVE EXAMPLE 5 | | | |
|---|---|---|---|
| | | COMPARATIVE EXAMPLE 5 | EXAMPLE 5 |
| Before coating: | Surface roughness Ra | 0.15 μm | 0.20 μm |
| | Surface hardness HV | 900 | 1200 |
| | Surface stress MPa | -500 | -1450 |
| After coating: | Service life, number of shots | 30000 | 150000 |

In both the Example 5 and the Comparative Example 5, compressive stresses in surfaces after the ceramic coating were -500 MPa.

Compressive stresses in surfaces of a base material coated with CrN (inside of a CrN film) were -400 MPa in the Comparative Example 5 and -800 MPa in the Example 5. The compressive stress in the surface of the base material in the Example 5 was extinguished due to heat caused by the ceramic coating.

However, the service life of the ceramic coating in the Example 5 was extended to 5 times. It is considered that, since the base material had high hardness of HV930 due to the nitriding, uniform nano-crystals were formed in the surface in the Example 5, so Cr was diffused inside even if the treatment temperature of the ceramic coating was low, resulting in increased adhesion strength. From a fact that half peak width in the Comparative Example 5 was 3.5, while half peak width in the Example 5 was 5.3, it can be understood that a metal structure of a surface layer in the Example 5 was minuter than a metal structure of a surface layer in the Comparative Example 5.

Example 6 (comparative)

In addition to the above-described Examples, in order to check variation of hardness, compressive stress, and half peak width, molds for hot working SKD61 were subjected to quenching and tempering so as to have hardness of HV570, and then subjected to blasting under the same processing conditions as the above-described Example 5 (Tables 8-1). After the blasting, surface hardness was HV790 and the compressive stresses were -1200 MPa.

FIG. 9 is a graph showing results of checking variation of hardness, compressive stress, and half peak width after temperature holding each test piece for one hour. FIG. 9 shows that the compressive stress is suddenly extinguished (the numerical value becomes lower) when the temperature becomes 300° C or more, and the hardness is suddenly extinguished (the numerical value becomes lower) when the temperature becomes 500°C or more, but the half peak width is effective (decrease in the numerical value is small) even at 500° C or more. Therefore, the hardness and the half peak width can be held when the temperature is equal to or lower than tempering temperature. In other words, since microstructure (nano-crystals) formed in a surface layer by the blasting according to the present invention is held without being broken even if the low-temperature ceramic coating according to the present invention is carried out, a ceramic component is diffused inside a metal product, thus, adhesion strength of a ceramic film is increased, resulting in extension effect of the service life.

**Claims**

**1.** A method for enhancing adhesion of low-temperature ceramic coating, comprising:

a blasting step using spherical shot of # 300-500 JIS 6001, the shot having hardness equal to or higher than hardness of a base material of a metal product, and intermittently ejecting the shot in the form of a fluid mixed with compressed air onto the metal product for a period of 0.1 seconds to 1 second, at intervals of 0.5 seconds to 5 seconds, at an ejection pressure of 0.2 MPa to 0.6 MPa, at an ejection speed of 150 m/sec to 250 m/sec, and at an ejection distance of 100 mm to 250 mm;
a smoothing step comprising removing protrusions of irregularities formed by the blasting step on the surface of the metal product by polishing the protrusions to form smooth portions on one-third to two-thirds of the area of the surface to be treated of the metal product; and
a low-temperature ceramic coating step comprising forming a ceramic film on the surface of the metal product at equal to or lower than 650 °C,
the blasting step followed by the smoothing step being carried out before the low-temperature ceramic coating step.

**2.** The method for enhancing adhesion of low-temperature ceramic coating according to claim 1, wherein the blasting step comprises carrying out the blasting in two stages under blasting conditions according to claim 1.

**3.** The method for enhancing adhesion of low-temperature ceramic coating according to any one of the preceding claims, wherein surface roughness of the metal product before the low-temperature ceramic coating step is 0.8 μm (Ra: arithmetic average roughness) or less.

**4.** The method for enhancing adhesion of low-temperature ceramic coating according to any one of the preceding claims, wherein nitriding is carried out to the metal product before the blasting step.

**5.** The method for enhancing adhesion of low-temperature ceramic coating according to claim 4, wherein treatment temperature of the nitriding is 500° C to 650° C.

**Patentansprüche**

**1.** Verfahren zur Verbesserung der Haftfähigkeit einer aus Niedertemperaturkeramik bestehenden Beschichtung, umfassend:

einen Schritt, in dem das Strahlen unter Anwendung von kugelförmigen Strahlmittelkörpern Nr. 300-500 nach JIS 6001 durchgeführt wird, wobei die Härte der Strahlmittelkörper gleich der Härte oder höher als die Härte des Grundmaterials des jeweiligen metallischen Erzeugnisses ist, wobei der Strahl in der Form eines Gemisches von Flüssigkeit und Druckluft gegen das metallische Erzeugnis diskontinuierlich geblasen wird, nämlich 0,1 bis 1 Sekunde lang in Zeitabständen von 0,5 bis 5 Sekunden, bei einem Strahldruck im Bereich von 0,2 MPa bis 0,6 MPa, bei einer Strahlgeschwindigkeit im Bereich von 150 m/s bis 250 m/s sowie bei einem Strahlabstand im Bereich von 100 mm bis 250 mm;
einen Abglätten beinhaltenden Schritt, in dem die durch das Strahlen entstandenen Vorsprünge von Unregelmäßigkeiten auf der Oberfläche des metallischen Erzeugnisses entfernt werden, wobei das Abglätten von Vorsprüngen mittels eines Poliervorgangs erfolgt, wodurch glatte Abschnitte im Bereich von einem Drittel bis zwei Dritteln der derart behandelten Oberfläche des metallischen Erzeugnisses erreicht werden; und
einen Schritt von Niedertemperaturkeramikbeschichtung, welcher Schritt die Bildung eines keramischen Films auf der Oberfläche des metallischen Erzeugnisses bei einer Temperatur, die gleich oder niedriger als 650 °C ist, umfasst,
wobei der das Strahlen umfassende Schritt sowie der anschliessende, das Abglätten umfassende Schritt vor dem die Niedertemperaturkeramikbeschichtung umfassenden Schritt durchgeführt werden.

**2.** Verfahren zur Verbesserung der Haftfähigkeit einer Niedertemperaturkeramikbeschichtung nach Anspruch 1, wobei der das Strahlen umfassende Schritt in zwei Stufen unter den Bedingungen nach Anspruch 1 durchgeführt wird.

**3.** Verfahren zur Verbesserung der Haftfähigkeit einer Niedertemperaturkeramikbeschichtung nach einem der vorhergehenden Ansprüche, wobei die Oberflächenrauheit des metallischen Erzeugnisses vor dem das Auftragen der Niedertemperaturkeramikbeschichtung umfassenden Schritt 0,8 μm (Ra: arithmetischer Mittenrauwert) oder weniger beträgt.

**4.** Verfahren zur Verbesserung der Haftfähigkeit einer aus Niedertemperaturkeramik bestehenden Beschichtung nach einem der vorhergehenden Ansprüche, wobei vor dem das Strahlen umfassenden Schritt das Nitrieren des metallischen Erzeugnisses durchgeführt wird.

**5.** Verfahren zur Verbesserung der Haftfähigkeit einer Niedertemperaturkeramikbeschichtung nach einem der vorhergehenden Ansprüche, wobei die Temperatur, bei der das metallische Erzeugnis durch das Nitrieren behandelt wird, im Bereich von 500° C bis 650° C liegt.

## Revendications

**1.** Procédé d'amélioration de l'adhérence d'un revêtement céramique basse température comprenant :

une étape de grenaillage à l'aide des grenailles d'acier n° 300-500 selon JIS 6001, les grenailles ayant une dureté égale ou supérieure à la dureté du matériau de base du produit métallique, consistant à projeter de manière interrompue des grenailles sous forme d'un liquide mélangé avec de l'air comprimé sur le produit métallique pendant une durée entre 0,1 et 1 seconde, à des intervalles compris entre 0,5 et 5 secondes, à une pression de projection comprise entre 0,2 MPa et 0,6 MPa, à une vitesse de projection comprise entre 150 m/s et 250 m/s et à une distance de projection comprise entre 100 mm et 250 mm;
une étape de lissage comprenant l'élimination des saillies entraînant la forme irrégulière de la surface du produit métallique et formées lors de l'étape de grenaillage, cette élimination des saillies consistant en polissage en créant des portions lisses sur une surface présentant d'un tiers à deux tiers de la surface ainsi traitée du produit métallique; et
une étape de dépôt basse température du revêtement céramique comprenant la formation d'une couche mince céramique sur la surface du produit métallique à une température égale ou inférieure à 650 °C,
l'étape de grenaillage suivie de l'étape de lissage étant effectuées avant l'étape de dépôt du revêtement céramique basse température.

**2.** Procédé d'amélioration de l'adhérence d'un revêtement céramique basse température selon la revendication 1, l'étape de grenaillage comprenant le grenaillage en deux étapes dans des conditions de grenaillage selon la revendication 1.

**3.** Procédé d'amélioration de l'adhérence d'un revêtement céramique basse température selon l'une quelconque des revendications précédentes, la rugosité de la surface du produit métallique avant l'étape de dépôt basse température du revêtement céramique étant 0,8 μm (Ra : écart moyen arithmétique du profil de rugosité) ou inférieure.

**4.** Procédé d'amélioration de l'adhérence d'un revêtement céramique basse température selon l'une quelconque des revendications précédentes, où avant l'étape de grenaillage, une nitruration du produit métallique est effectuée.

**5.** Procédé d'amélioration de l'adhérence d'un revêtement céramique basse température selon la revendication 4, la température de nitruration étant comprise entre 500 °C et 650 °C.

FIG. 1

WPC treatment : $\phi$ 55 $\mu$ m

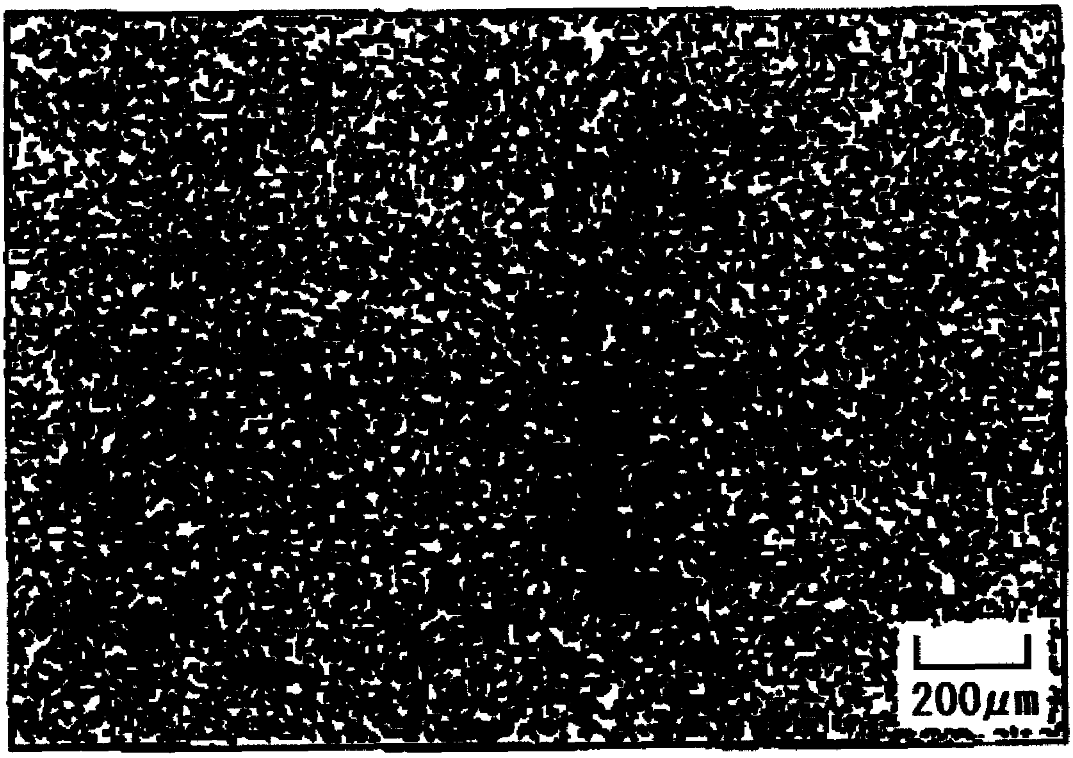

FIG. 2

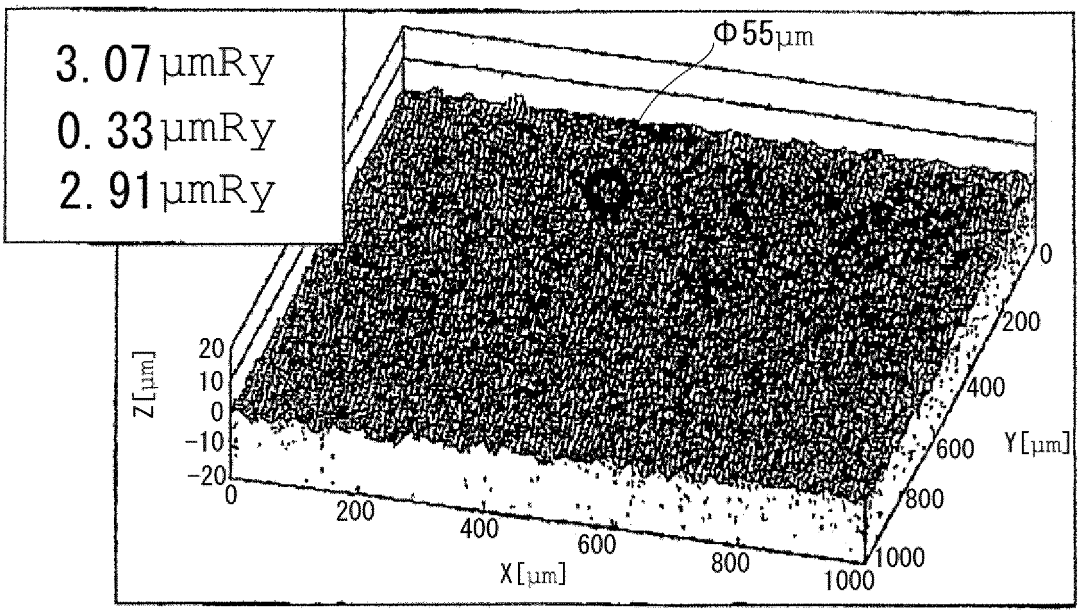
3. 07 μmRy
0. 33 μmRy
2. 91 μmRy
Φ55μm
Z[μm]
20
10
0
−10
−20
0
200
400
600
800
1000
X[μm]
Y[μm]

FIG. 3

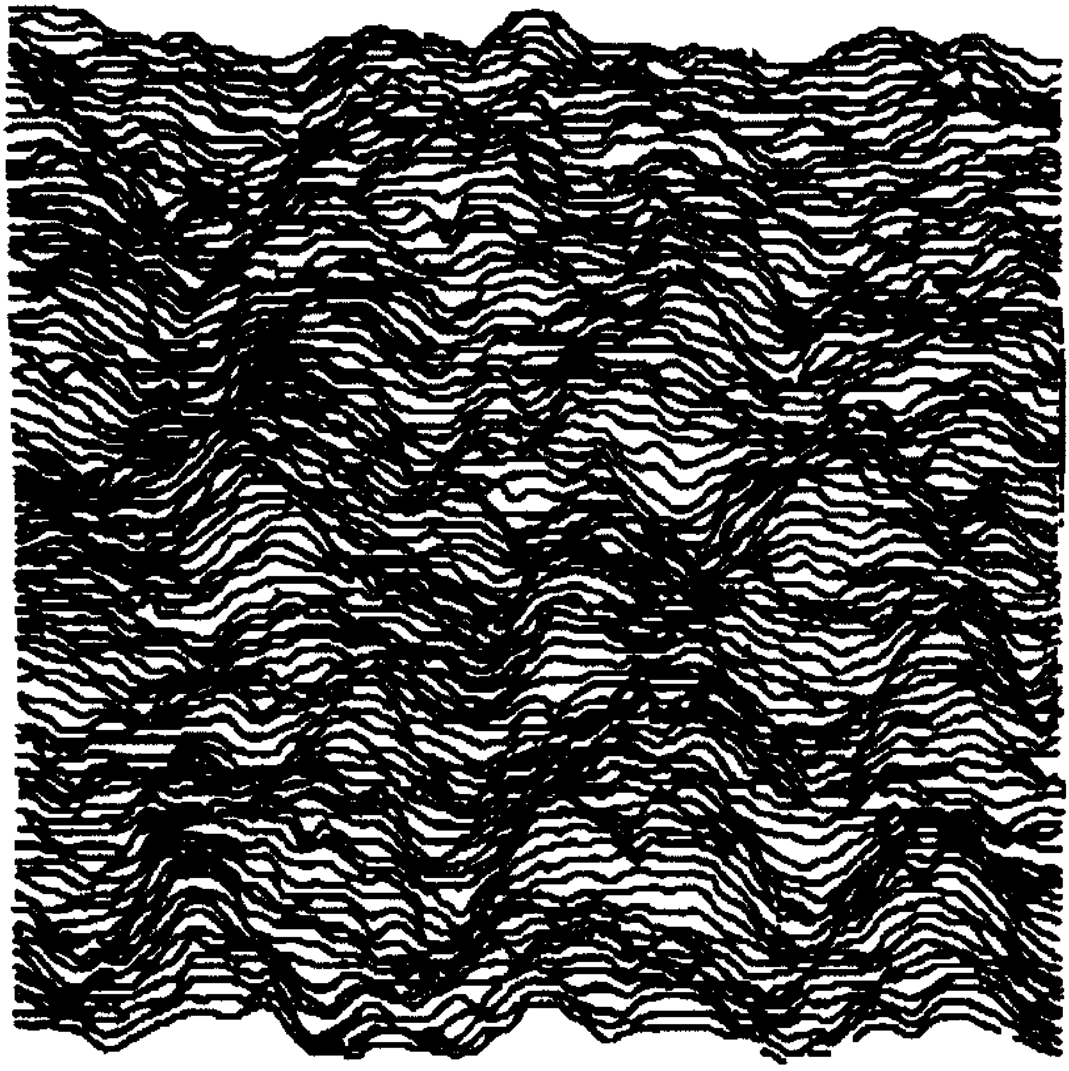

FIG. 4

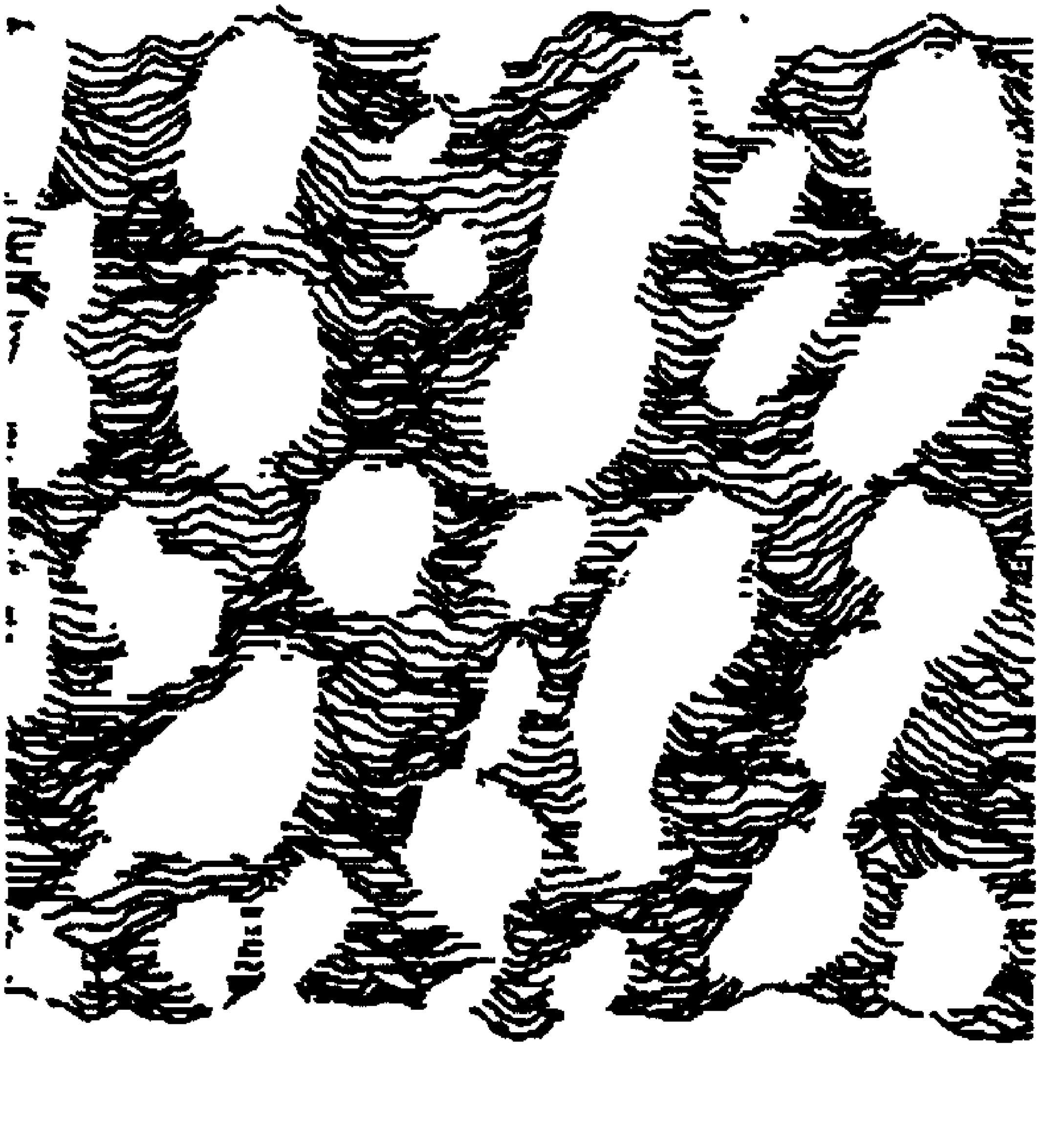

FIG. 5

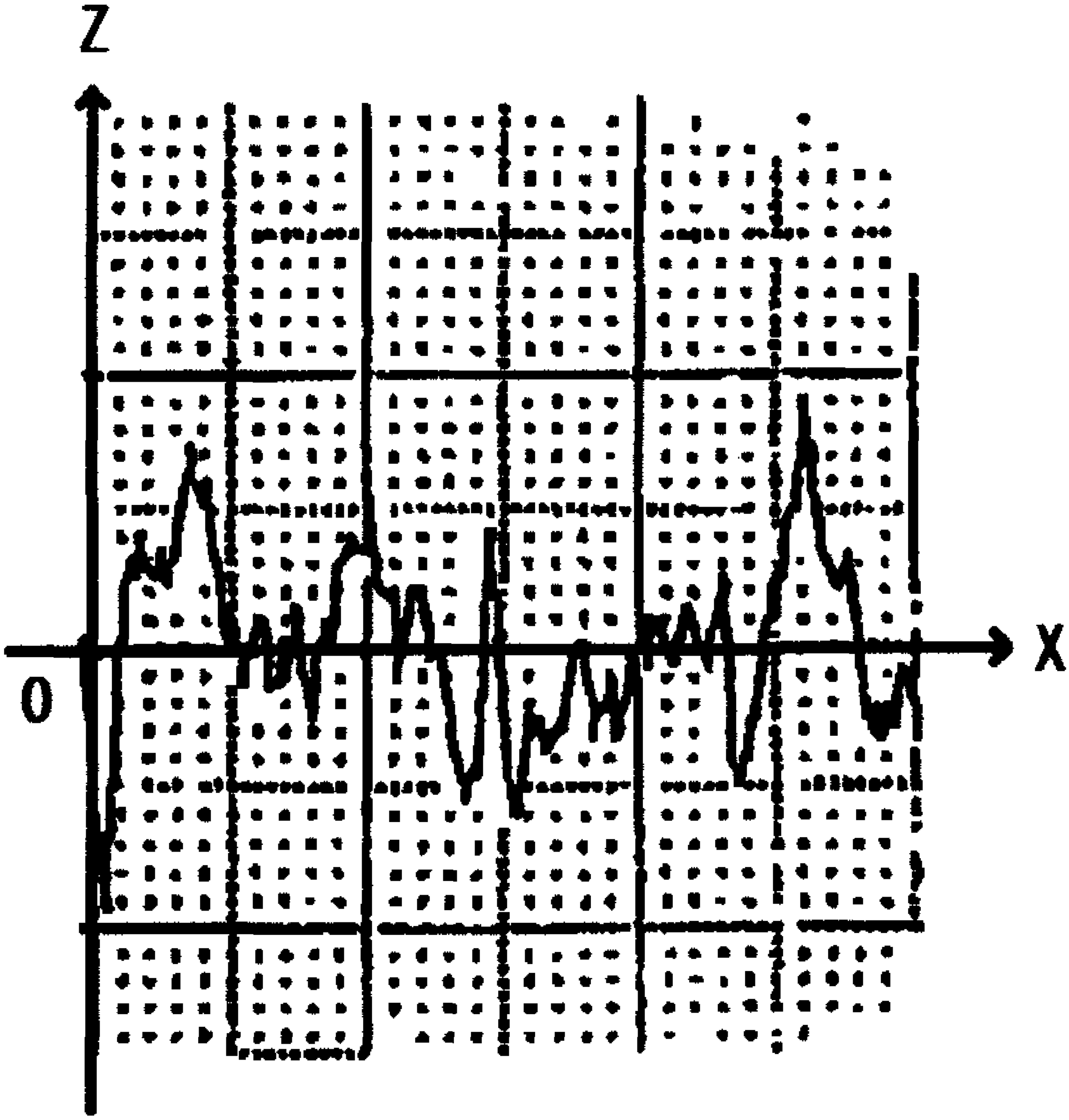

FIG. 6

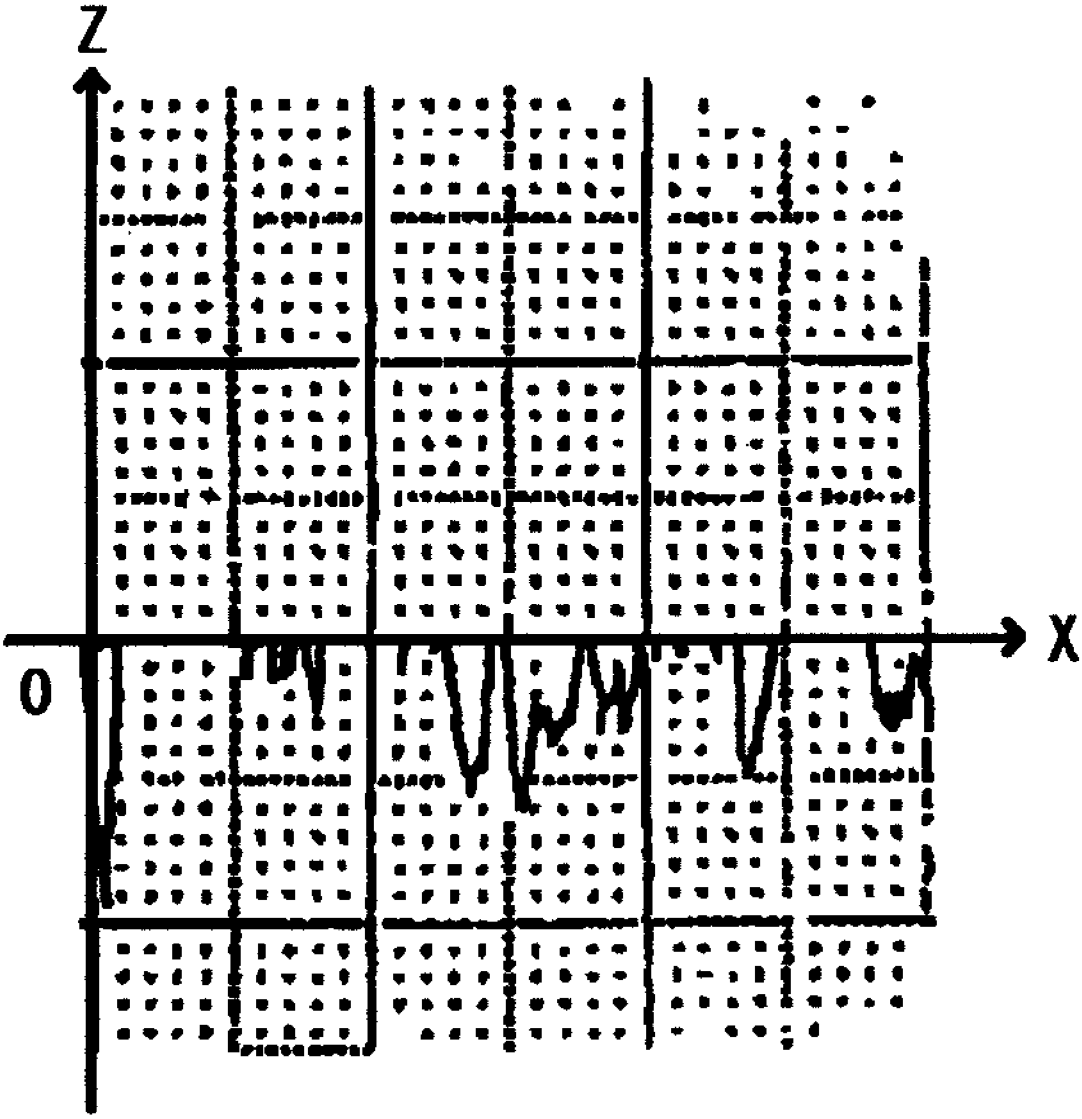

# FIG. 7

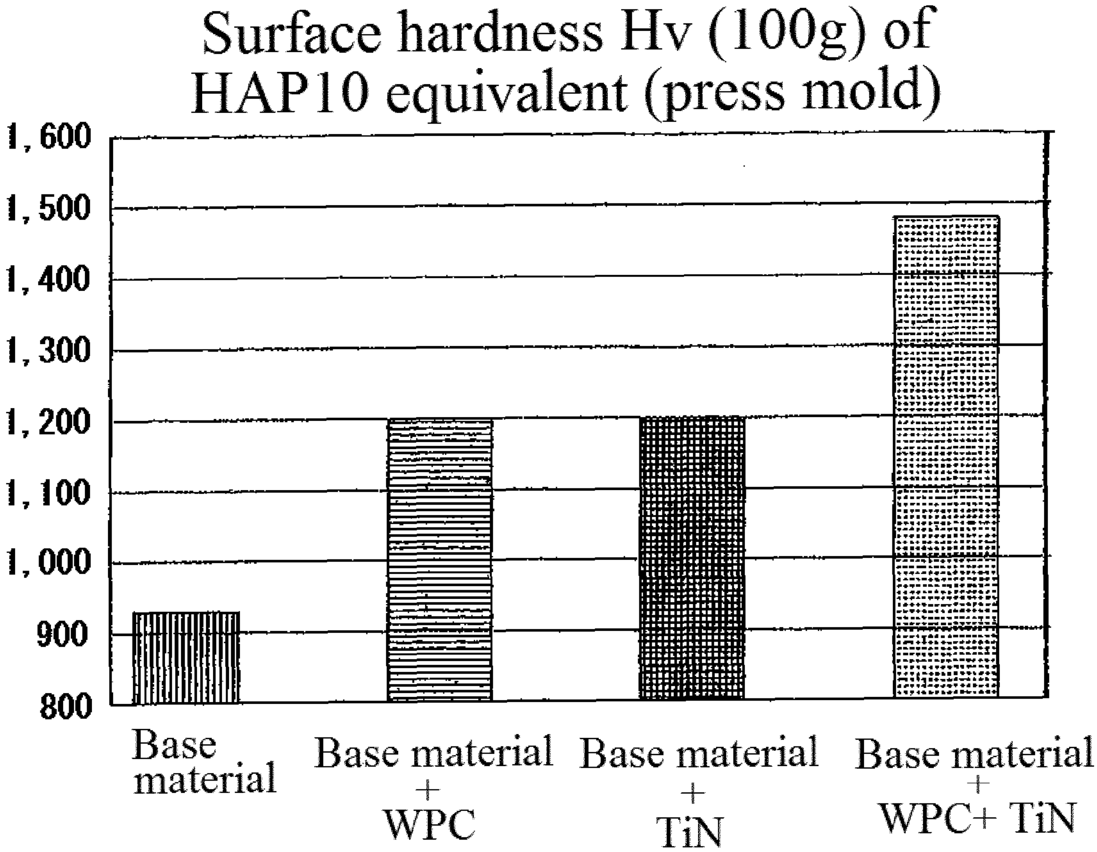
Surface hardness Hv (100g) of
HAP10 equivalent (press mold)
1,600
1,500
1,400
1,300
1,200
1,100
1,000
900
800
Base material
Base material + WPC
Base material + TiN
Base material + WPC+ TiN

# FIG. 8

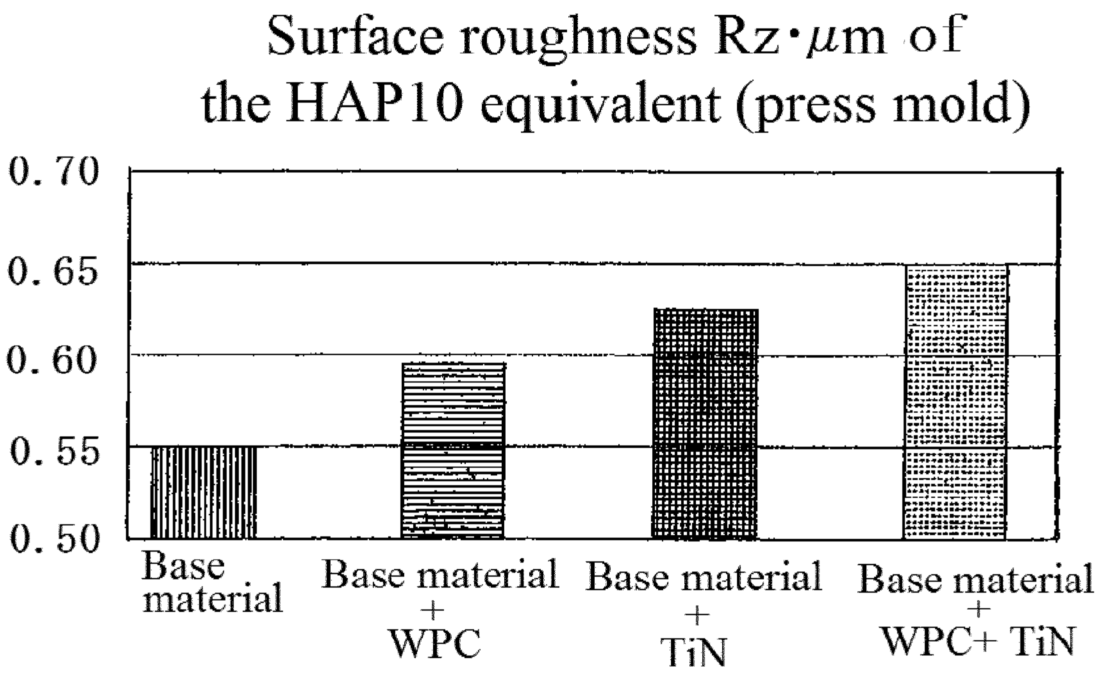
Surface roughness Rz·μm of
the HAP10 equivalent (press mold)
0.70
0.65
0.60
0.55
0.50
Base material
Base material + WPC
Base material + TiN
Base material + WPC+ TiN

# FIG. 9

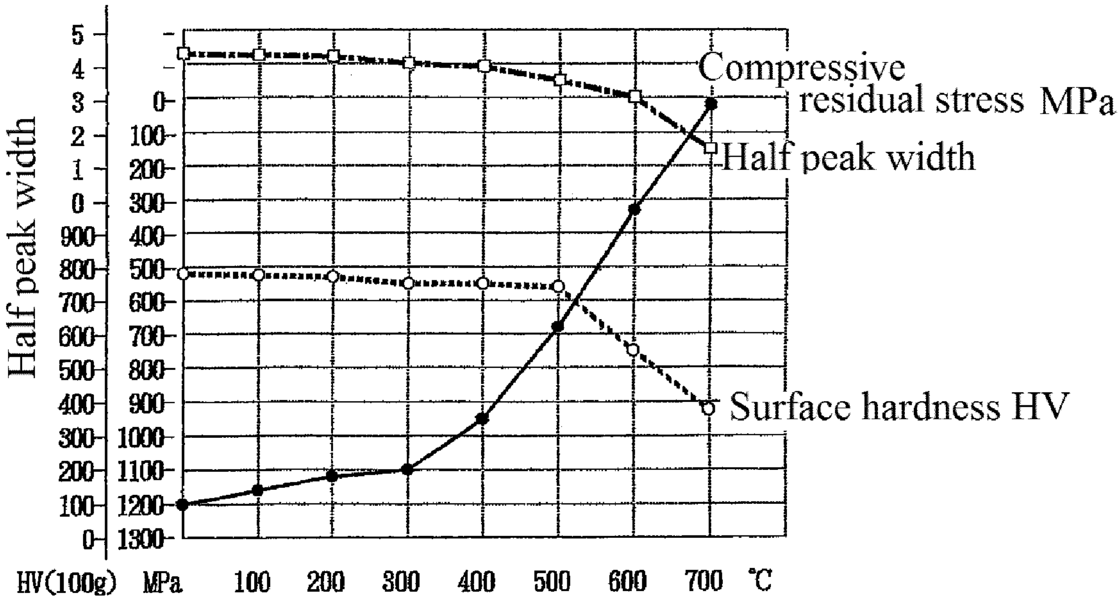
Half peak width
5
4
3
2
1
0
900
800
700
600
500
400
300
200
100
0
0
100
200
300
400
500
600
700
800
900
1000
1100
1200
1300
HV(100g)
MPa
100
200
300
400
500
600
700
℃
Compressive residual stress MPa
Half peak width
Surface hardness HV

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2010025198 A
- US 2012144890 A